# EUROPEAN PATENT SPECIFICATION

(11) **EP 1 490 972 B1**
(45) Date of publication and mention of the grant of the patent: **01.08.2007**
(21) Application number: 03744929.5
(22) Date of filing: 26.02.2003
(51) Int. Cl.: H03K 17/785

(54) **OPTOELECTRONIC RECEIVER CIRCUIT FOR DIGITAL COMMUNICATION**
OPTOELEKTRONISCHE EMPFÄNGERSCHALTUNG FÜR DIE DIGITALE KOMMUNIKATION
CIRCUIT RECEPTEUR OPTOELECTRONIQUE POUR COMMUNICATION NUMERIQUE

(30) Priority: 26.03.2002 EP 02076186
(43) Date of publication of application: 29.12.2004
(73) Proprietor: Koninklijke Philips Electronics N.V., 5621 BA Eindhoven (NL)
(72) Inventor: BEIJ, Marcel, NL-5656 AA Eindhoven (NL); BUIJ, Arnold, W., NL-5656 AA Eindhoven (NL)
(74) Representative: Bosma, Rudolphus Hubertus Antonius
(86) International application number: PCT/IB2003/000751
(87) International publication number: WO 2003/081777

(56) References cited:
- CA-A- 1 299 245
- DE-A- 3 102 256
- US-A- 4 197 471
- US-A- 4 347 445

## Description

The invention relates to an interface for digital communication comprising
- signal terminals for connection to a source supplying a bus voltage,
- a switching element coupled between the signal terminals,
- a control circuit for controlling the conductive state of the switching element comprising
   - supply voltage terminals,
   - means for generating a supply voltage between the supply voltage terminals,
   - a series arrangement comprising a light sensor for receiving digital light signals and an impedance coupled between the supply voltage terminals,
   - an out put terminal coupled to the series arrangement and to a control electrode of the switching element.

Such an interface is known from a digital interface system that is known as Digital Addressable Lighting Interface (DALI). Such an interface is known from US 4 197 471. In the known interface the switching element and the control circuit are used to send signals from a slave to a master. The slave is equipped with a light emitting diode that transmits light signals. These light signals are sensed by a light sensor that forms an opto-isolator output stage and together with the light emitting diode forms an optocoupler. The optocoupler functions as an opto-isolator. When it senses light, the light sensor becomes conductive and a current flows through the series arrangement comprised in the control circuit, so that a voltage is present over the impedance that is part of the series arrangement. In the known interface this impedance is an ohmic resistor. When it senses no light, the light sensor becomes non-conductive, so that the current through the series arrangement and the voltage over the impedance both drop to zero. In the known interface the voltage over the impedance is also present at the control electrode of the switching element. As a result the switching element is rendered conductive when the light sensor is conductive so that the switching element forms a short circuit between the signal terminals. The source that supplies the bus voltage is so constructed that it can only maintain the bus voltage between the signal terminals when the current through the signal terminals is below a predetermined value. Because of the short circuit the current through the signal terminals is in fact higher than the predetermined value, causing the voltage between the signal terminals to become substantially equal to zero. When the light sensor is non-conductive, the switching element is also rendered non-conductive so that the voltage between the signal terminals equals the bus voltage.

The known interface suffers several serious drawbacks. First of all the DALI standard requires that the rising and falling edge of a DALI signal must be longer than 10 microseconds (to reduce EMI) but must not exceed 100 microseconds. In other words, in case of a typical bus voltage of 16 Volt the slope of the rising and falling edge of the signal, that is generated by the switching element and is present between the signal terminals, may not exceed 1.6 MV/sec. Practical embodiments of the known interface only meet this requirement in case of a heavy capacitive load, but not in most practical circumstances.

The invention aims to provide a simple interface for digital communication that causes a relatively low amount of EMI.

An interface as mentioned in the opening paragraph is therefor in accordance with the invention characterized in that the interface is further equipped with a first circuit comprising a capacitor and coupled between the control electrode and a signal terminal and a second circuit comprising an ohmic resistor and coupled between the output terminal of the control circuit and the control electrode of the switching element.

It has been found that because of the presence of the first circuit and the second circuit in an interface according to the present invention, an interface according to the present invention causes only a relatively small amount of EMI.

Good results have been obtained for embodiments of an interface according to the present invention in which the impedance comprised in the control circuit comprises an ohmic resistor.

Apart from rising and falling edges in the signal, that is present between the signal terminals and is generated by the switching element, that are too steep, the known interface also suffers from another drawback, being the fact that the time delay of the rising edge when the switching element is switched off differs substantially from the time delay of the falling edge when the switching element is switched on. This difference causes a disturbance of the "high/low-ratio" of the signal generated by the switching element. Since the DALI standard requires that the "high/low-ratio" is approximately equal to 1, a disturbance of this ratio can lead to misinterpretation of the signal by the receiving master. To overcome the difference in the time delays of a rising and a falling edge respectively, the impedance comprised in the control circuit preferably comprises a parallel arrangement of an ohmic resistor and a zener diode. It has been found that the difference in the time delays can be minimized in case the zener voltage Vz of the zener diode is chosen such that 1.6*Vt < Vz < 2.4*Vt, preferably such that 1.8*Vt < Vz < 2.2*Vt, wherein Vt is the threshold voltage of the switching element.

In a preferred embodiment of an interface according to the invention, the means for generating a supply voltage comprise unidirectional means and buffer capacitor means. Thus the means for generating a supply voltage are realized in a very simple and dependable way.

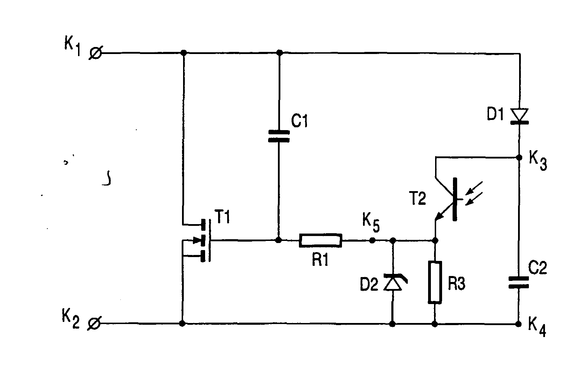

An embodiment of an interface according to the invention will be explained making reference to a drawing. In the drawing
Fig. 1 shows an embodiment of an interface according to the invention.

In Fig. 1, K1 and K2 are signal terminals between which a bus voltage is present during operation. Signal terminals K1 and K2 are connected by means of a switching element T1. Switching element T1 is shunted by a series arrangement of diode D1 and capacitor C2. In this embodiment diode D 1 forms unidirectional means and capacitor C2 forms buffer capacitor means. Diode D 1 and capacitor C2 together form means for generating a supply voltage. A first side of capacitor C2 is connected to supply voltage terminal K3. A second side of capacitor C2 is connected to supply voltage terminal K4. Capacitor C2 is shunted by a series arrangement of light sensor T2 and ohmic resistor R3. Ohmic resistor R3 is shunted by zener diode D2. The zener voltage of the zener diode is chosen substantially equal to twice the threshold voltage of switching element T1. A common terminal of ohmic resistor R3, zener diode D2 and light sensor T2 forms an output terminal K5. Supply voltage terminals K3 and K4, diode D1 and capacitor C2, light sensor T2, ohmic resistor R3, zener diode D2 and output terminal K5 together form a control circuit for controlling the conductive state of the switching element T1. The parallel arrangement of ohmic resistor R3 and zener diode D2 forms an impedance comprised in the control circuit. Output terminal K5 is connected to a control electrode of switching element T1 by means of ohmic resistor R1. In this embodiment ohmic resistor R1 forms a second circuit coupled between output terminal of the control circuit and the control electrode of the switching element T1. The control electrode of switching element T1 is connected to signal terminal K1 by means of capacitor C1. In this embodiment capacitor C1 forms a first circuit coupled between the control electrode and a signal terminal.

The operation of the interface shown in Fig. 1 is as follows.

When the signal terminals K1 and K2 are connected to a source supplying a bus voltage, the bus voltage that is present between the signal terminals, when the interface is in use, charges capacitor C2 to a voltage that is substantially equal to the bus voltage. When the interface shown in Fig 1 is connected to a slave that is equipped with a light emitting diode that transmits light signals, these light signals render the light sensor T2 that is comprised in the control circuit alternately conductive and non-conductive. When the light sensor T2 is conductive, the voltage over capacitor C2 causes a current to flow through the light sensor T2 and ohmic resistor R3. The voltage over ohmic resistor R3 renders the switching element T1 conductive. The switching element T1 becomes a short circuit causing the current supplied by the source for supplying the bus voltage to increase above a predetermined value. This predetermined value is the highest current that the source for supplying the bus voltage can supply while maintaining the bus voltage between the signal terminals. Since the actual current is higher than the predetermined value, the voltage between the signal terminals drops. The presence of C1 and R1 makes sure that switching element T1 does not immediately become conductive but only gradually. As a consequence the slope of this drop is decreased by the presence of ohmic resistor R1 and capacitor C1. During the conductiveness of the light sensor T2, capacitor C1 is charged by a current flowing through the light sensor T2, ohmic resistor R1 and capacitor C1. Similarly, when the light sensor is non-conductive, the voltage over ohmic resistor R3 drops to zero, so that the switching element T1 is rendered non-conductive and the voltage between the signal terminals increases. The steepness of the slope of this latter increase is again limited by the presence of ohmic resistor R1 and capacitor C1, since switching element T1 is not rendered non-conductive immediately but gradually. During the non-conductiveness of the light sensor T2, capacitor C1 is discharged by a current that flows from signal terminal K1 through capacitor C1, ohmic resistors R1 and R3 to signal terminal K2. By choosing the zener voltage approximately equal to twice the threshold voltage of the switching element T1 and by choosing ohmic resistor R3 relatively small (with respect to ohmic resistor R1), the current that charges capacitor C 1 is approximately equal to the current that discharges C1. As a consequence the time delay of the rising edge of the signal present between the signal terminals is approximately equal to the time delay of the falling edge of that signal. This in turn causes the disturbance of the "high/low-ratio" of the signal present between the signal terminals to be very small.

An experiment has been conducted in which two interfaces were used. The first interface was a practical embodiment of the interface shown in Fig. 1 while the second interface did *not* comprise the capacitor C1, the ohmic resistor R1 and the zener diode D2 but was otherwise identical to the first interface. The steepness of the slopes of the signal present between the signal terminals of each of the interfaces was evaluated for the same signal transmitted by the same light emitting diode and a bus voltage of 16 V. For the second interface it was found that the slope of the rising edge was 28 MV/sec while the time delay was 8.5 microseconds and the slope of the falling edge was 17MV/sec while the time delay was 3.5 microseconds. For the first interface it was found that the slope of the rising edge was 1. 1 MV/sec while the time delay was 28 microseconds and the slope of the falling edge was 0.5MV/sec and a delay of 38 microseconds. It can be concluded that the slopes of the rising and falling edges of the signal meet the DALI requirements in case of the first interface but not in case of the second. Additionally the time delays of the rising edge and the falling edge of the signal are more similar in case of the first interface than in case of the second interface. As a consequence the "high/low-ratio" of the signal present between the signal terminals is very close to 1.

## Claims

1. Interface for digital communication comprising:
- signal terminals (K1, K2) for connection to a source supplying a bus voltage,
- a switching element (T1) coupled between the signal terminals,
- a control circuit for controlling the conductive state of the switching element comprising:
- supply voltage terminals (K3, K4),
- means (D1, C2) for generating a supply voltage between the supply voltage terminals,
- a series arrangement comprising a light sensor (T2) for receiving digital light signals and an impedance (R3, D2) coupled between the supply voltage terminals,
- an output terminal (K5) coupled to the series arrangement and to a control electrode of the switching element,
- a first circuit comprising a capacitor (C1) and coupled between the control electrode and a signal terminal, and
- a second circuit comprising an ohmic resistor (R1) and coupled between the output terminal of the control circuit and the control electrode of the switching element, **characterized in that** the impedance comprised in the control circuit comprises a parallel arrangement of an ohmic resistor (R3) and a zener diode (D2).

2. Interface according to claim 1, wherein the zener voltage Vz of the zener diode is chosen such that 1.6*Vt < Vz < 2.4*Vt, wherein Vt is the threshold voltage of the switching element.

3. Interface according to claim 2, wherein the zener voltage Vz of the zener diode is chosen such that 1.8*Vt < Vz < 2.2*Vt, wherein Vt is the threshold voltage of the switching element.

4. Interface according to claim 1, 2 or 3, wherein the means for generating a supply voltage comprise unidirectional means (D1) and buffer capacitor means (C2).

## Patentansprüche

1. Schnittstelle zur digitalen Kommunikation, umfassend:
- Signalanschlüsse (K1, K2) zur Verbindung mit einer Quelle, die eine Busspannung bereitstellt,
- ein Schaltelement (T1), das zwischen den Signalanschlüssen gekoppelt ist,
- einen Steuerkreis zum Steuern des leitenden Zustands des Schaltelements, umfassend
- Versorgungsspannungsanschlüsse (K3, K4),
- Mittel (D1, C2) zum Erzeugen einer Versorgungsspannung zwischen den Versorgungsspannungsanschlüssen,
- eine Reihenanordnung, die einen Lichtsensor (T2) zum Empfangen von digitalen Lichtsignalen und eine Impedanz (R3, D2), die zwischen den Versorgungsspannungsanschlüssen gekoppelt ist, umfasst,
- einen Ausgangsanschluss (K5), der an die Reihenanordnung und an eine Steuerelektrode des Schaltelements gekoppelt ist,
- eine erste Schaltung, die einen Kondensator (C1) umfasst und zwischen der Steuerelektrode und einem Signalanschluss gekoppelt ist,
- eine zweite Schaltung, die einen ohmschen Widerstand (R1) umfasst und zwischen dem Ausgangsanschluss des Steuerkreises und der Steuerelektrode des Schaltelements gekoppelt ist, **dadurch gekennzeichnet, dass** die Impedanz, die in dem Steuerkreis enthalten ist, eine Parallelanordnung von einem ohmschen Widerstand (R3) und einer Zenerdiode (D2) umfasst.

2. Schnittstelle nach Anspruch 1, in der die Zenerspannung Vz der Zenerdiode so gewählt ist, dass 1,6*Vt < Vz < 2,4*Vt, wobei Vt die Schwellenspannung des Schaltelements ist.

3. Schnittstelle nach Anspruch 2, in der die Zenerspannung Vz der Zenerdiode so gewählt ist, dass 1,8*Vt < Vz < 2,2*Vt, wobei Vt die Schwellenspannung des Schaltelements ist.

4. Schnittstelle nach Anspruch 1, 2 oder 3, in der die Mittel zum Erzeugen einer Versorgungsspannung unidirektionale Mittel (D1) und Pufferkondensator-Mittel (C2) umfassen.

## Revendications

1. Interface pour la communication numérique comprenant
- des bornes de signal (K1, K2) pour être connectées à une source fournissant une tension de bus,
- un élément de commutation (T1) qui est couplé entre les bornes de signal,
- un circuit de commande pour commander l'état conducteur de l'élément de communication comprenant
- des bornes de tension d'alimentation (K3, K4),
- des moyens (D1, C2) pour générer une tension d'alimentation entre les bornes de tension d'alimentation,
- un montage en série comprenant un détecteur de lumière (T2) pour recevoir des signaux lumineux numériques et une impédance (R3, D2) qui est couplée entre les bornes de tension d'alimentation,
- une borne de sortie (K5) qui est couplée au montage en série et à une électrode de commande de l'élément de commutation,
- un premier circuit comprenant un condensateur (C1) et étant couplé entre l'électrode de commande et une borne de signal, et
- un second circuit comprenant une résistance ohmique (R1) et étant couplé entre la borne de sortie du circuit de commande et l'électrode de commande de l'élément de commutation, **caractérisée en ce que** l'impédance qui est contenue dans le circuit de commande comprend un montage en parallèle d'une résistance ohmique (R3) et d'une diode de Zener (D2).

2. Interface selon la revendication 1, dans laquelle la diode de Zener Vz de la diode de Zener est choisie de telle façon que 1,6*Vt < Vz < 2,4*Vt où Vt est la tension de seuil de l'élément de commutation.

3. Interface selon la revendication 2, dans laquelle la tension de Zener Vz de la diode de Zener est choisie de telle façon que 1,8*Vt < Vz < 2,2*Vt où Vt est la tension de seuil de l'élément de commutation.

4. Interface selon la revendication 1, 2 ou 3, dans laquelle les moyens pour générer une tension d'alimentation comprennent des moyens unidirectionnels (D1) et des moyens de condensateur tampon (C2).
